# EUROPEAN PATENT APPLICATION

(11) **EP 2 906 023 A1**
(43) Date of publication of application: **12.08.2015**
(21) Application number: 13843774.4
(22) Date of filing: 01.10.2013
(51) Int. Cl.: H05B 33/10, H01L 51/50

(54) **METHOD FOR MANUFACTURING ORGNAIC ELECTROLUMINESCENT DEVICE**

(30) Priority: 04.10.2012 JP 2012221825
(71) Applicant: Nitto Denko Corporation, Ibaraki-shi, Osaka 567-8680 (JP)
(72) Inventor: OSAKI Yoshinori, Ibaraki-shi Osaka 567-8680 (JP)
(74) Representative: Grünecker Patent- und Rechtsanwälte PartG mbB
(86) International application number: PCT/JP2013/076672
(87) International publication number: WO 2014/054622

(57) **Abstract**

An organic electroluminescence device is manufactured using a roll-to-roll method. The manufacturing method includes the steps of forming a plurality of organic EL elements 3 on a belt-shaped flexible substrate 2, laminating a sealing film 5 on the plurality of organic EL elements 3 through a thermosetting or photo-curing adhesive layer in an uncured state, and winding a belt-shaped laminated body10 having the belt-shaped flexible substrate 2, the organic EL elements 3, and the sealing film 5, into a roll. The adhesive layer in the uncured state is provided on a back surface of the sealing film 5 except for both end parts of the back surface of the sealing film 5, and after the step of winding the laminated body, the adhesive layer is cured by applying heat or light to the laminated body 10.

## Description

### TECHNICAL FIELD

The present invention relates to a method for manufacturing an organic electroluminescence device.

### BACKGROUND ART

Hereinafter, the organic electroluminescence is referred to as "organic EL".

Conventionally, the organic EL device including a substrate, an organic EL element provided on the substrate, and a sealing layer provided on the organic EL element is known. The organic EL element includes a first electrode, a second electrode, and an organic layer provided between the first and second electrodes.

As a method for manufacturing the organic EL device, a roll-to-roll method has been known.

The roll-to-roll method is a manufacturing method in which a belt-shaped flexible substrate wound into a roll is intermittently or continuously unwound and fed, an organic EL element, a sealing layer, and the like are sequentially formed on the substrate, and then a laminated body is wound into a roll again.

A manufacturing method using the roll-to-roll method includes a step of unwinding and feeding the belt-shaped flexible substrate wound into the roll, a step of forming the plurality of organic EL elements on the belt-shaped flexible substrate, a step of laminating a belt-shaped sealing film having a thermosetting adhesive layer in an uncured state, on the plurality of organic EL elements through the adhesive layer, a step of fixing the sealing film to the organic EL elements by heating the sealing film to cure the adhesive layer, a step of winding a belt-shaped laminated body having the belt-shaped flexible substrate, the organic EL elements, and the sealing film into a roll, and a step of obtaining an individual organic EL device by unwinding the belt-shaped laminated body and cutting its required position (Patent Document 1).

The step of curing the adhesive layer is performed while the flexible substrate is fed, but to heat the adhesive layer provided on the flexible substrate that is being fed, a large heating apparatus is needed.

In this respect, as a conceivable way, instead of curing the adhesive layer while the flexible substrate is being fed, the heating is performed after the sealing film has been laminated on the organic EL elements, and then the laminated body has been wound into the roll.

However, when the laminated body is wound before the adhesive layer is heated (that is, under the condition that the adhesive layer is in the uncured state), an adhesive agent constituting the adhesive layer protrudes in some cases from an edge of the sealing film because a winding pressure is applied to the laminated body wound into the roll. When the adhesive agent protrudes, the laminated body wound into the roll causes blocking, so that after that, the laminated body cannot be smoothly unwound.

[Patent Document 1] JP 2010-097803 A

### SUMMARY OF INVENTION

An object of the present invention is to provide a method for manufacturing an organic EL device using a roll-to-roll method, in which an adhesive layer can be cured with a relatively small curing process apparatus, and blocking can be prevented from occurring in a laminated body wound into a roll.

A first method for manufacturing an organic EL device using a roll-to-roll method includes the steps of forming a plurality of organic EL elements on a belt-shaped flexible substrate, laminating a sealing film on the plurality of organic EL elements through a thermosetting or photo-curing adhesive layer in an uncured state, and winding a belt-shaped laminated body having the belt-shaped flexible substrate, the plurality of organic EL elements, and the sealing film, into a roll, wherein the adhesive layer in the uncured state is provided on a back surface of the sealing film except for both end parts of the back surface of the sealing film, and after the step of winding the laminated body, the adhesive layer is cured by applying heat or light to the laminated body.

A second method for manufacturing an organic EL device using a roll-to-roll method includes the steps of forming a plurality of organic EL elements on a belt-shaped flexible substrate, laminating a sealing film on the plurality of organic EL elements through a thermosetting or photo-curing adhesive layer in an uncured state, and winding a belt-shaped laminated body having the belt-shaped flexible substrate, the plurality of organic EL elements, and the sealing film, into a roll, wherein the adhesive layer in the uncured state is provided on a back surface of the sealing film, and a thickness of the adhesive layer in the uncured state formed on both end parts of the sealing film (i.e., a thickness of a part of the adhesive layer) is smaller than a thickness of the adhesive layer formed in a region other than the both end parts of the sealing film (i.e., a thickness of the other part of the adhesive layer), and after the step of winding the laminated body, the adhesive layer is cured by applying heat or light to the laminated body.

In a preferable method for manufacturing an organic EL device, after the step of winding the laminated body, the adhesive layer is cured by applying heat to the laminated body wound into the roll.

In a preferable method for manufacturing an organic EL device, after the step of winding the laminated body, the laminated body wound into the roll is unwound, the laminated body is cut in a boundary part between the adjacent organic EL elements, and the adhesive layer is cured by applying heat or light to a cut piece.

In a preferable method for manufacturing an organic EL device, the sealing film has a belt shape or a sheet shape.

According to the method for manufacturing the organic EL device in the present invention, the curing process for the uncured adhesive layer is not performed while the laminated body is being fed in the roll-to-roll method, so that the uncured adhesive layer can be cured with a relatively small curing process apparatus.

Furthermore, the uncured adhesive layer is not provided on the both end parts of the sealing film, or the uncured adhesive layer is thinly provided on the both end parts of the sealing film, so that after the laminated body having the uncured adhesive layer has been wound into the roll, the blocking can be prevented from occurring in the laminated body.

### BRIEF DESCRIPTION OF DRAWINGS

Fig. 1 is a plan view of an organic EL device according to one embodiment of the present invention.
Fig. 2 is an enlarged sectional view taken along the line II-II in Fig. 1 (an enlarged sectional view of an organic EL device taken along in the thickness direction).
Fig. 3 is an enlarged sectional view of an organic EL device according to the other embodiment of the present invention taken along in the thickness direction.
Fig. 4 is a frame format of each process in the manufacturing method according to the first embodiment of the present invention.
Fig. 5 is a plan view illustrating the state of forming a plurality of organic EL elements on a belt-shaped flexible substrate.
Fig. 6 is a back view of a belt-shaped sealing film used in the first embodiment.
Fig. 7 is a plan view of a belt-shaped sealing film adhered temporarily to a separator.
Fig. 8 is an enlarged sectional view taken along the line VIII-VIII in Fig. 7.
Fig. 9 is a schematic enlarged side view of a laminating apparatus used when laminating a sealing film.
Fig. 10 is a plan view of a laminated body with a sealing film laminated thereon.
Fig. 11 is a plan view when obtaining a cutting piece by cutting a laminated body with a sealing film laminated thereon in the manufacturing method according to the second embodiment of the present invention.
Fig. 12 is a plan view of a sealing film on which an uncured adhesive layer is provided used in the manufacturing method according to the third embodiment of the present invention.
Fig. 13 is an enlarged sectional view taken along the line XIII-XIII in Fig. 12.
Fig. 14 is a plan view of a sealing film on which an uncured adhesive layer is provided used in the manufacturing method according to the fourth embodiment of the present invention.
Fig. 15 is an enlarged sectional view taken along the line XV-XV in Fig. 14.
Fig. 16 is an enlarged sectional view taken along the line XVI-XVI in Fig. 14.

### DESCRIPTION OF EMBODIMENTS

Hereinafter, the present invention will be described with reference to the drawings. It should be noted that dimensions such as a layer thickness and a length in the drawings are different from actual dimensions.

In this specification, the terms "first" and "second" may be added as prefixes. These prefixes, however, are only added in order to distinguish the terms and do not have specific meaning such as order and relative merits. The "belt shape" means a substantially rectangular shape in which a length in one direction is, for example, sufficiently larger than a length in the other direction. The belt shape is a substantially rectangular shape in which a length in one direction is 10 times or more, preferably 30 times or more, more preferably 100 times or more of a length in the other direction. The "longitudinal direction" is one direction of the belt shape (direction parallel to the longer side of the belt shape), and the "short direction" is the other direction of the belt shape (direction parallel to the shorter side of the belt shape). The "planar shape" is a shape viewed from a vertical direction with respect to a surface of a substrate. The wording "PPP to QQQ" indicates "PPP or more and QQQ or less".

### [Configuration of organic EL device]

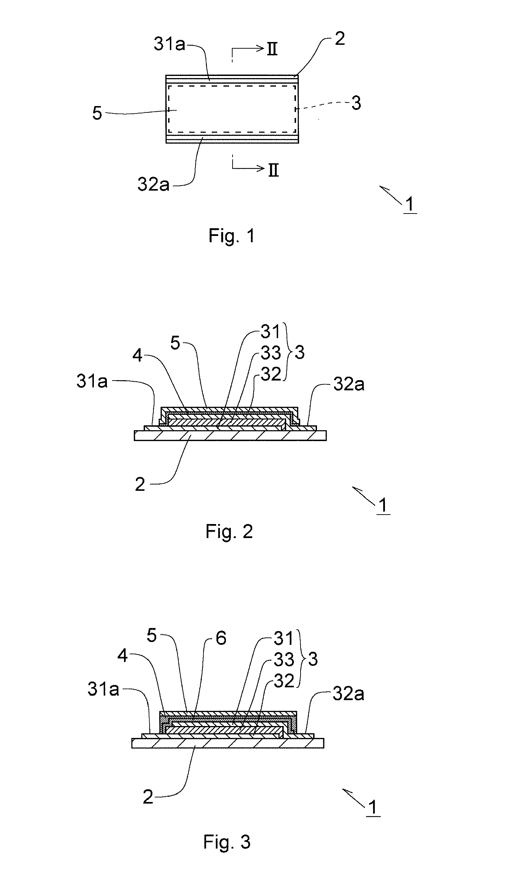

As illustrated in Figs. 1 and 2, an organic EL device 1 in the present invention includes a substrate 2 having a substantially rectangular shape in a planar view, an organic EL element 3 provided on the substrate 2, and a sealing film 5 fixed onto the organic EL element 3 through an adhesive layer 4.

The organic EL element 3 includes a first electrode 31 having a terminal 31a, a second electrode 32 having a terminal 32a, and an organic layer 33 provided between the electrodes 31 and 32.

In the organic EL element 3, the terminal 31a of the first electrode 31 is arranged on a first side and the terminal 32a of the second electrode 32 is arranged on a second side with respect to the organic layer 33. The first side and the second side are opposite to each other, and when referring to Fig. 1, the first side is the upper side and the second side is the lower side.

The sealing film 5 is provided on the organic EL element 3 so as to cover a surface of the organic EL element 3, exclusive of the terminals 31a and 32a.

As illustrated in Fig. 2, a laminate structure of the organic EL device 1 includes the substrate 2, the first electrode 31 provided on the substrate 2, the organic layer 33 provided on the first electrode 31, the second electrode 32 provided on the organic layer 33, and the sealing film 5 provided on the second electrode 32.

When the substrate 2 has electric conductivity, an insulating layer (not illustrated) is provided between the substrate 2 and the first electrode 31 in order to prevent an electrical short-circuit.

The organic EL element 3 is formed into a substantially rectangular shape in a planar view, for example. Of course, a planar shape of the organic EL element 3 is not limited to a substantially rectangular shape, but it may shape like a substantially square or circular shape.

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is provided on the surface of the first electrode 31, exclusive of the end part (terminal 31a) of the first electrode 31 arranged on the first side.

The second electrode 32 is provided on the organic layer 33 so as to cover the surface of the organic layer 33. For forming the terminal 32a of the second electrode 32, the end part (terminal 32a) of the second electrode 32 is drawn from the end part of the organic layer 33 to the second side.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

The sealing film 5 is adhered to the surface of the organic EL element 3 (the second electrode 32) with a cured adhesive layer 4 interposed therebetween so as not to cover the terminals 31a and 32a of the first electrode 31 and the second electrode 32.

The sealing film 5 is a layer for preventing infiltration of oxygen, water vapor, and the like into the organic EL element 3.

The sealing film 5 wholly covers the organic EL element 3 in an airtight manner, exclusive of the terminals 31a and 32a. Specifically, the sealing film 5 is adhered to the surface of the second electrode 32, exclusive of the terminals 31a and 32a. Furthermore, as illustrated in Fig.2, the sealing film 5 is adhered to the side surfaces of the organic EL element 3. The peripheral edge part of the sealing film 5 is adhered to the surface of the substrate 2, the surface of the first electrode 31, and the surface of the second electrode 32.

In addition, as illustrated in Fig. 3, a barrier layer 6 may be provided under the sealing film 5 as necessary. The barrier layer 6 is provided on the surface of the second electrode 32, and the sealing film 5 is provided on the surface of the barrier layer 6.

In the example illustrated in Fig. 2, the sealing film 5 is adhered to the peripheral end face of the organic EL element 3. However, as illustrated in Fig. 3, the sealing film 5 may not be adhered so as to cover the peripheral end face of the organic EL element 3. In this case, the sealing film 5 is adhered only to the surface side of the organic EL element 3.

An organic EL device 1 of the present invention can be used as a light emitting panel such as an illuminating device, an image display and the like as the organic layer 33 is formed of a light emitting material.

Hereinafter, taking the organic EL device having a light emitting layer as an example, a manufacturing method and a forming material thereof are explained below.

### [First embodiment of method for manufacturing organic EL device]

The method for manufacturing the organic EL device of the present invention is performed using a roll-to-roll method.

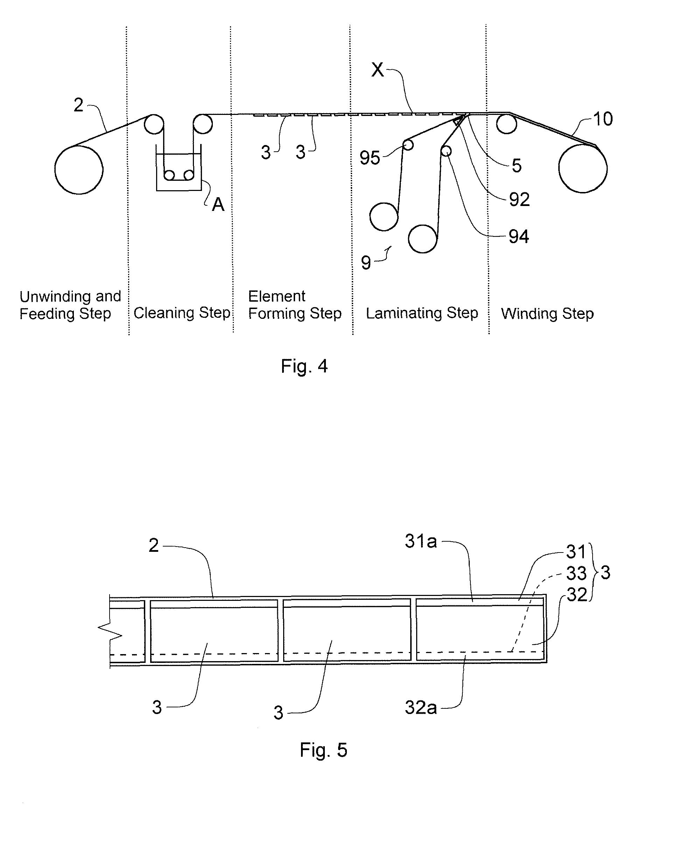

As illustrated in Fig. 4, the method for manufacturing the organic EL device includes the steps of unwinding and feeding a belt-shaped flexible substrate 2, forming a plurality of organic EL elements on the belt-shaped flexible substrate 2, laminating a sealing film 5 on the plurality of organic EL elements through a thermosetting or photo-curing adhesive layer in an uncured state, and winding a belt-shaped laminated body having the belt-shaped flexible substrate 2, the organic EL elements, and the sealing film 5, into a roll. The uncured adhesive layer is provided on a back surface of the sealing film 5 except for both end parts of the back surface of the sealing film 5. As needed, a cleaning step is provided between the unwinding and feeding step and the element forming step.

According to the manufacturing method in the first embodiment, after the winding step, the adhesive layer is cured by applying heat or light to the laminated body wound into the roll.

In this specification, it is to be noted that the back surface of the sealing film means a surface opposed to the organic EL element.

### (Unwinding and feeding step)

The belt-shaped flexible substrate 2 is a flexible thin flat shape and has been wound into a roll as illustrated in Fig. 4. This flexible substrate 2 wound into the roll is unwound in its longitudinal direction, and fed to a manufacturing line. While it is fed, the organic EL elements are sequentially formed on a surface of the flexible substrate 2.

A length of the belt-shaped flexible substrate (a length in the longitudinal direction) is not particularly limited, but it is 10 m to 1000 m, for example. In addition, a width of the flexible substrate (a length in the short direction) is not particularly limited, but for example, it is 10 mm to 300 mm, preferably 10 mm to 100 mm. A thickness of the flexible substrate is also not particularly limited, and may be appropriately set in consideration of the material thereof. When a metal substrate or a synthetic resin substrate is used as the flexible substrate, a thickness thereof is 10µm to 50µm, for example.

The flexible substrate may be either transparent or opaque. When a bottom emission organic EL device is formed, a transparent substrate is used.

In this specification, the index of transparency may be, for example, a total light transmittance of 70% or more, preferably 80% or more. It is to be noted that the total light transmittance is a value measured by a measurement method conforming to JIS K7105 (Method of Testing Optical Characteristics of Plastics).

While a material of the flexible substrate is not particularly limited, examples thereof include glass substrates, metal substrates, synthetic resin substrates, and ceramic substrates. Examples of the synthetic resin substrate include synthetic resin films such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). Examples of the metal substrate include flexible thin plates formed of stainless steel, copper, titanium, aluminum, and alloys.

Furthermore, for preventing a rise in temperature of the organic EL device at the time of driving, the flexible substrate is preferably excellent in heat dissipation. For preventing infiltration of oxygen and water vapor into the organic EL device, the flexible substrate preferably has gas and water vapor barrier properties.

When a metal substrate is used, an insulating layer is provided on a surface of the metal substrate in order to insulate the substrate against an electrode formed on the surface thereof.

### (Element forming step)

The step of forming the organic EL elements is performed similarly to a conventional step.

Briefly, as illustrated in Fig. 4, the unwound flexible substrate 2 is cleaned in a cleaning tank A and dried as needed. After the cleaning and drying step, the first electrode is formed on the surface of the substrate.

As the formation method of the first electrode, an optimum method can be employed depending on the formation material, and examples of the method include a sputtering method, a vapor deposition method, and an ink-jet method. In a case where an anode is formed of metal, the vapor deposition method is used.

Furthermore, the substrate having the first electrode previously patterned may be used. In the case where the substrate has the previously formed electrode, it is cleaned and dried after unwound from the roll.

An organic layer is formed on the surface of the first electrode, exclusive of a terminal thereof. An organic layer can be formed by forming a positive hole transport layer, a light emitting layer, and an electron transport layer in this order on the surface of the first electrode, for example. As the formation method of the positive hole transport layer and the electron transport layer, an optimum method can be employed depending on the formation material, and examples of the method include a sputtering method, a vapor deposition method, an ink-jet method, a coating method, and the like.

As the formation method of the light emitting layer, an optimum method can be employed depending on the formation material, but usually it is formed by a vapor deposition method.

Subsequently, the second electrode is formed on the surface of the organic layer. The second electrode is formed so as not to cover the terminal of the first electrode. As the formation method of the second electrode, an optimum method can be employed depending on the formation material, and examples of the method include a sputtering method, a vapor deposition method, an ink-jet method, and the like.

In this way, a plurality of organic EL elements 3 are formed at predetermined intervals on the belt-shaped flexible substrate in the longitudinal direction.

Furthermore, as needed, the barrier layer may be provided on the surface of the second electrode.

Fig. 5 illustrates the flexible substrate 2 after the element forming step in which the plurality of organic EL elements 3 are formed on the flexible substrate 2. After the element forming step, the organic EL elements 3 each including the first electrode 31 having the terminal 31a, the second electrode 32 having the terminal 32a, and the organic layer 33 sandwiched between both of the electrodes are arranged on the surface of the flexible substrate 2 at predetermined intervals.

The interval between the organic EL elements is not particularly limited and may be appropriately set. As will be described below, a boundary part between the adjacent organic EL elements is cut with a cutting tool, whereby the organic EL device can be individually obtained. Therefore, the interval between the organic EL elements is to be set so that the organic EL element is not damaged by the cutting tool.

For example, the interval between the organic EL elements is 0.5 mm or more, and preferably 1 mm or more. Meanwhile, when the length of the interval is too long, the number of the organic EL devices that can be provided in the one flexible substrate is reduced. From the above viewpoints, the interval is preferably 5 mm or less, and more preferably 3 mm or less, for example.

A first electrode is an anode, for example.

The formation material of the first electrode (anode) is not particularly limited, but examples include indium tin oxide (ITO); indium tin oxide including silicon oxide (ITSO); aluminum; gold; platinum; nickel; tungsten; copper; and an alloy. When a bottom emission organic EL device is formed, a transparent first electrode is used.

A thickness of the first electrode is not particularly limited, but it is usually 0.01 µm to 1.0 µm.

An organic layer is a laminate structure composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a positive hole transport layer.

The organic layer used in the present invention can have any of the structures (A) to (C) mentioned above.

The organic layer having the structure (A) is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer is provided on the surface of the first electrode, and the positive hole transport layer may be provided on the surface of the positive hole injection layer. The positive hole injection layer is a layer having a function of aiding injection of a positive hole from the anode layer to the positive hole transport layer.

A formation material of the positive hole transport layer is not particularly limited as long as the formation material has a positive hole transport function. Examples of the formation material for the positive hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)-9,9'-spiro-bisfluorene (abbreviation: Spiro-NPB); a polymer compound; and the like. The formation material of the positive hole transport layer may be used singly or in combination of two or more formation materials. Furthermore, the positive hole transport layer may be a multi-layer structure having two or more layers.

A thickness of the positive hole transport layer is not particularly limited, but the thickness of 1 nm to 500 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (abbreviation: Alq₃), and the like.

Furthermore, as the formation material for the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emitting layer may include such as the formation material for the positive hole transport layer mentioned above, the formation material of the electron transport layer mentioned below, and various additives.

A thickness of the light emitting layer is not particularly limited, but the thickness of 2 nm to 500 nm is preferable, for example.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer may be provided on the surface of the electron transport layer, and the second electrode may be provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used singly or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage.

A second electrode is a cathode, for example.

A formation material of the second electrode is not particularly limited, but a transparent second electrode is used when a top emission organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, but it is usually 0.01 µm to 1.0 µm.

A barrier layer is provided for protecting the organic EL element and preventing infiltration of moisture and oxygen.

A forming material for the barrier layer is not particularly limited, but examples include a metal oxide film, an oxynitride film, a nitride film, and a carbide nitride oxide film. Examples of the metal oxide film include MgO, SiO, SiₓO_{y}, Al₂O₃, GeO, and Ti₂O.

The barrier layer is preferably a silicon carbide nitride oxide film (SiOCN), a silicon oxynitride film (SiON), and a silicon nitride film (SiN).

A thickness of the barrier layer is not particularly limited, but it is 50 nm to 50 µm, for example.

### (Laminating step)

In the laminating step, the sealing film is put and temporarily attached on each of the plurality of organic EL elements.

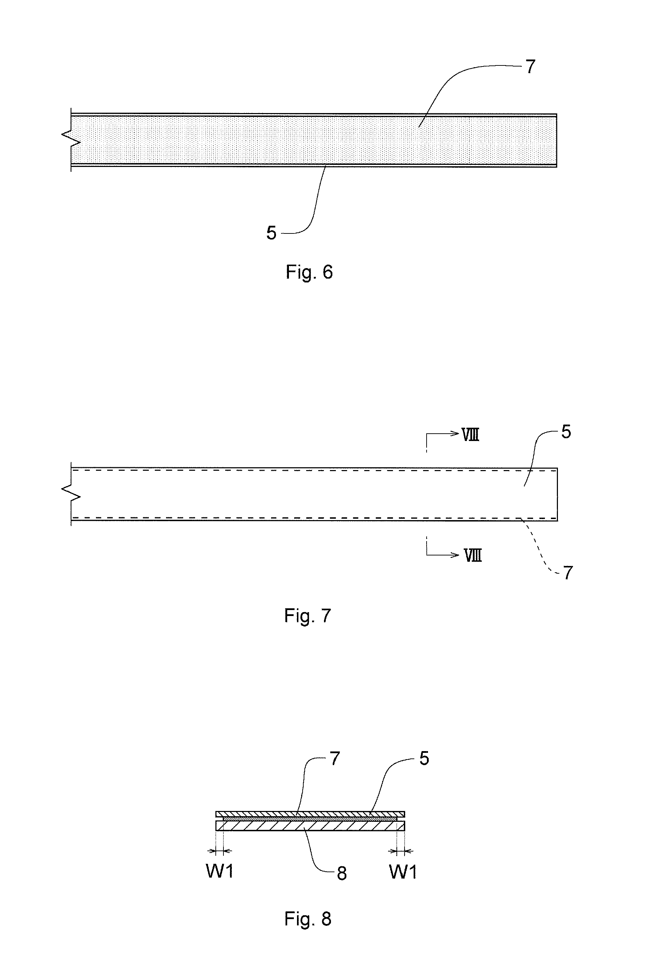

Fig. 6 is a view taken from the back surface of the belt-shaped sealing film 5 to be used in the roll-to-roll method. Referring to Fig. 6, an uncured adhesive layer 7 is provided in a region where numerous dots are illustrated.

Figs. 7 and 8 illustrate a state in which the sealing film 5 is temporarily attached to a separator 8 (the sealing film with a separator).

The sealing film 5 has a belt shape, for example.

To temporarily attach the sealing film 5 to the organic EL element, the uncured adhesive layer 7 is provided on the back surface of the sealing film 5.

The uncured adhesive layer 7 is provided on the back surface of the sealing film 5 except for the both end parts of the sealing film 5. That is, the adhesive layer 4 is not provided at both end parts (a first end part and a second end part) of the sealing film 5. Furthermore, the first end part of the sealing film 5 extend parts in the longitudinal direction of the flexible substrate, and the second end part is opposed to the first end part and extend parts in the longitudinal direction of the flexible substrate.

Furthermore, in the illustrated example, the uncured adhesive layer is not provided only at the both end parts (the first end part and the second end part) of the belt-shaped sealing film 5, but according to the present invention, the uncured adhesive layer may not be provided at end parts (not illustrated) extending in a direction perpendicular to the above both end parts. In the belt-shaped sealing film 5, the end part extending in the direction perpendicular to the above both end parts is the end part extending along a short-length direction of the sealing film.

When the sealing film 5 is supplied to the manufacturing line, the uncured adhesive layer 7 is temporarily attached to the separator 8 in general as illustrated in Figs. 7 and 8, in order to prevent the adhesive layer 4 from coming in contact with a foreign material.

The planar shape of the separator 8 is a belt shape. As the separator 8, a thin flat shaped article having a surface subjected to a mold release treatment so that the uncured adhesive layer 7 is easily peeled off is used. The forming material for the separator is not particularly limited, and examples thereof include a synthetic resin film, a synthetic paper, and a paper subjected to a mold release treatment.

While the belt-shaped sealing film is fed in synchronization with the conveyance of the belt-shaped flexible substrate, the sealing film is laminated on the surface of the organic EL element except for each terminal.

The sealing film is provided for preventing infiltration of moisture and oxygen into the organic EL element.

As a material for forming the sealing film, a synthetic resin film such as an ethylene tetrafluoroethyl copolymer (ETFE), high density polyethylene (HDPE), oriented polypropylene (OPP), polystyrene (PS), polymethyl methacrylate (PMMA), oriented nylon (ONy), polyethylene terephthalate (PET), polycarbonate (PC), polyimide, polyether styrene (PES), or polyethylene naphthalate (PEN) can be suitably used. As the sealing film 5, a flexible glass plate and a metallic plate may be used. The sealing film may be either transparent or opaque. When a top emission organic EL device is formed, a transparent sealing film is used.

A thickness of the sealing film is not particularly limited, but for example, it is 5 µm to 1 mm and preferably 10 µm to 500 µm.

As illustrated in Fig. 8, a width W1 not having the uncured adhesive layer 7 is not particularly limited. However, when the width is too small, a blocking prevention effect could not be sufficiently provided, and when the width is too large, the end part of the sealing film may not be adhered to the organic EL element, and the end part of the sealing film may turn upward. From the above viewpoints, the width W1 not having the uncured adhesive layer 7 is preferably 10 µm to 500 µm.

A thickness of the uncured adhesive layer is not particularly limited. However, when the thickness is too small, the sealing film may not be adhered to the organic EL element with sufficient strength, and when the thickness is too large, the sealing film may be displaced after the sealing film has been laminated on the organic EL element.

From the above viewpoints, the thickness of the uncured adhesive layer is preferably 1 µm to 30 µm. Furthermore, the adhesive layer has no difference in thickness in its planar direction, and is uniform in thickness.

As an adhesive agent constituting the adhesive layer, a thermosetting or photo-curing adhesive agent may be used.

The thermosetting adhesive agent includes an adhesive agent containing an epoxy resin, a phenol resin, a polyurethane resin, or a melamine resin as a major component. As the photo-curing adhesive agent, an ultraviolet curing adhesive agent is representatively used. The ultraviolet curing adhesive agent includes an adhesive agent containing an ultraviolet curing acrylic resin, an ultraviolet curing urethane acrylate resin, an ultraviolet curing polyester acrylate resin, an ultraviolet curing polyurethane resin, an ultraviolet curing epoxy acrylate resin, or an ultraviolet curing imide acrylate resin, as a major component.

In addition, as needed, a barrier layer may be provided under the sealing film (not illustrated). The barrier layer is provided on the back surface of the sealing film, and the adhesive layer is provided on a back surface of the barrier layer. The barrier layer provided under the sealing film may be similar to the barrier layer of the organic EL element.

As illustrated in Fig. 4, while a substrate X on which the organic EL elements have been formed in the element forming step is fed to a downstream side of the manufacturing line, the sealing film 5 is laminated on it.

The sealing film 5 is laminated on the surface of the organic EL element 3 with a laminating apparatus 9.

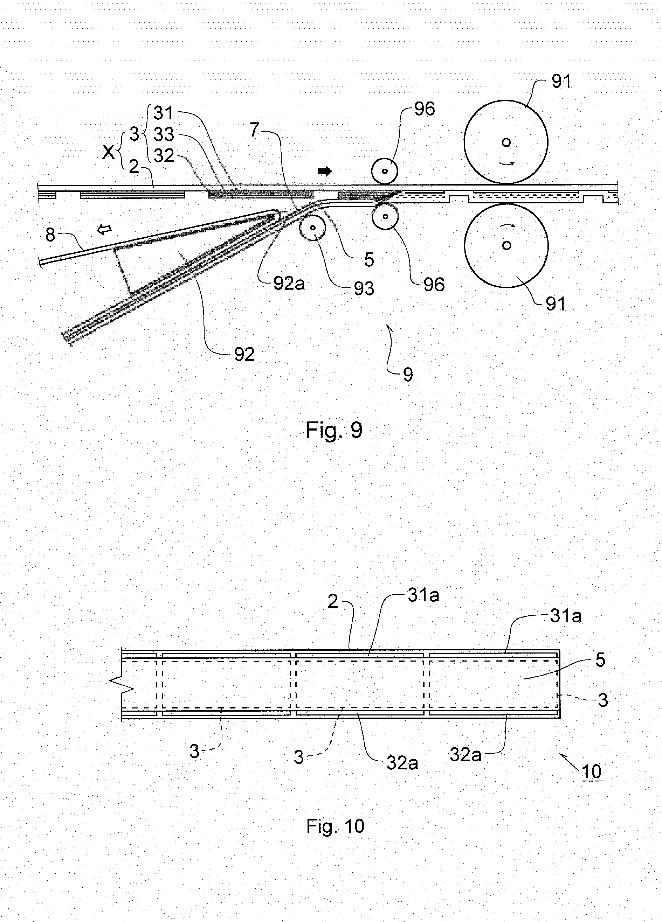

Fig. 9 is a schematic side view of a laminating apparatus of a sealing film.

This laminating apparatus 9 includes a pair of conveyance rollers 91 for feeding an organic EL element-formed substrate X in the longitudinal direction, the peel plate 92 for separating the separator 8 and the sealing film 5 from each other, a guide roller 93 disposed at a leading end part 92a of the peel plate 92, the conveyance roller 94 for feeding the sealing film with a separator to the peel plate 92, a collection roller 95 for collecting the separator 8, and a pair of pressing rollers 96 for pressing the surface of the sealing film 5 peeled off from the separator. The conveyance roller 94 and the collection roller 95 are not illustrated in Fig. 9, so Fig. 4 may be used as a reference.

The peel plate 92 is a plate-shaped body formed in the shape of an acute angled triangle in side view. The peel plate 92 is disposed such that the leading end part 92a (acute-angled portion) thereof is positioned in the vicinity of a surface of the organic EL element-formed substrate X. The distance between the leading end part 92a of the peel plate 92 and the surface of the organic EL element-formed substrate X is not particularly limited. Of course, when the above-mentioned distance is excessively small, the leading end part 92a of the peel plate 92 may come into contact with the surface of the organic EL element 3 to damage the surface of the organic EL element 3. On the other hand, when the above-mentioned distance is excessively long, the sealing film 5 peeled off by the peel plate 92 may not be transferred to the surface of the organic EL element 3. In view of these considerations, the distance between the leading end part 92a of the peel plate 92 and the surface of the organic EL element-formed substrate X is preferably 2 mm or more, more preferably 3 mm or more. The upper limit of the above-mentioned distance is, for example, 20 mm or less, preferably 10 mm or less although depending on a size of the sealing film 5.

The sealing film with a separator is fed to the peel plate 92 in synchronization with feeding of the organic EL element-formed substrate X.

In addition, the sealing film with the separator may be continuously fed, or may be intermittently fed by a length of the one organic EL element.

At the leading end part 92a of the peel plate 92, only the separator 8 is turned around and collected. In Fig.9, the void arrow shows a direction in which the separator is collected, and the black arrow shows a direction in which the organic EL element-formed substrate is fed.

As the separator is turned around at the leading end part 92a of the peel plate 92, interlayer peeling occurs between the uncured adhesive layer 7 and the separator 8, so that the sealing film 5 is separated from the separator 8 together with the uncured adhesive layer 7.

When the uncured adhesive layer 7 comes in touch with the surface of the organic EL element 3, the sealing film 5 is laminated on the organic EL element 3. The sealing film 5 is laminated on the surface of the organic EL element 3 (second electrode 32) except for the terminal of the first electrode 31 arranged on the first side along the longitudinal direction of the flexible substrate, and the terminal of the second electrode 32 arranged on the second side along the longitudinal direction.

The surface of the sealing film 5 laminated on the organic EL element 3 is pressed by the pressing roller 96, and the sealing film 5 is in close contact with both end part surfaces of the organic EL element 3.

According to the present invention, the uncured adhesive layer 7 is provided except for the both end parts of the sealing film 5. After the sealing film 5 has been laminated on the organic EL element and the sealing film 5 has been pressed, the uncured adhesive layer 7 is spread to the both end parts of the sealing film 5, and the both end parts of the sealing film 5 are in close contact with the organic EL element 3. Thus, since the uncured adhesive layer 7 is not provided on the both end parts of the sealing film 5, the adhesive layer 4 that has been spread to the both end parts of the sealing film 5 can be prevented from protruding from both edges of the sealing film 5.

Thus, as illustrated in Fig. 10, there is provided a laminated body 10 in which the organic EL elements and the sealing film 5 are sequentially laminated on the surface of the flexible substrate 2.

### (Winding step)

The laminated body is wound into a roll.

When the laminated body is wound into the roll, the adhesive layer is still in the uncured state.

According to the present invention, as described above, the adhesive layer 7 does not protrude from the both edges of the sealing film 5, so that blocking (adhering at the edge of the laminated body by the adhesive agent) can be prevented from generating after the laminated body has been wound into the roll.

### (Curing step of adhesive layer)

The laminated body wound into the roll is moved into a curing process apparatus as it is, and the uncured adhesive layer is cured (not illustrated).

By curing the adhesive layer, the sealing film is adhered to the organic EL element and fixed to it.

The curing process apparatus is appropriately set according to the kind of the adhesive agent in the adhesive layer. When the adhesive agent is the thermosetting type, a heating apparatus is used as the curing process apparatus. When the adhesive agent is the photo-curing type, a light irradiation apparatus such as an ultraviolet irradiation apparatus is used as the curing process apparatus.

Heating conditions such as a heating temperature and heating time of the heating apparatus are set so that the uncured thermosetting adhesive agent is cured.

Light irradiation conditions such as a light wavelength, light intensity, and an irradiation time of the light irradiation apparatus are set so that the uncured photo-curing adhesive agent is cured.

In addition, the light from the light irradiation apparatus affects an outside of the laminated body wound into the roll, but it may not sufficiently affect an inside (center core) of the roll. Meanwhile, the heat is likely to affect the inside of the laminated body wound into the roll. Therefore, the thermosetting uncured adhesive layer is preferably used as the uncured adhesive layer in the method for curing the uncured adhesive layer in the laminated body wound into the roll.

According to the present invention, the curing step of the uncured adhesive layer is not performed while the laminated body is fed but performed after the laminated body has been wound into the roll. In the case where the adhesive layer is cured while the laminated body is fed in the roll-to-roll method, a considerably large curing process apparatus is needed. In this respect, according to the present invention, the curing process of the adhesive layer is performed away from the manufacturing line in the roll-to-roll method, so that the adhesive layer can be cured by a relatively small curing process apparatus.

In particular, as the curing process is performed while the laminated body has been wound into the roll, more adhesive layers can be cured in one curing process.

### (Cutting step)

The laminated body after the adhesive layer has been cured is the plurality of organic EL devices continuously connected in the longitudinal direction.

The laminated body is unwound from the roll, and the laminated body is cut in the boundary part of the adjacent organic EL elements with a cutting toll, whereby the organic EL device can be individually provided.

A cutting method with the cutting tool includes a mechanical cutting with a blade having a knife-edge shape or a rotary blade, and a laser beam irradiation cutting.

In this way, the organic EL device can be obtained as illustrated in Figs. 1 and 2.

### [Second embodiment of method for manufacturing organic EL device]

According to the manufacturing method in the second embodiment, after the step of winding the laminated body, the laminated body wound into the roll is unwound, the boundary part between the adjacent organic EL elements is cut, and heat or light is applied to the cut pieces to cure the uncured adhesive layers. That is, according to the manufacturing method in the second embodiment, unlike the first embodiment in which the uncured adhesive layer is cured in the rolled-up state, the uncured adhesive layer is cured after the laminated body has been cut.

Hereinafter, descriptions are omitted for the same configuration and effect as the manufacturing method in the first embodiment, and the same term and reference number are incorporated.

According to the second embodiment, the unwinding and feeding step, the element forming step, the laminating step, and the winding step are the same as those in the first embodiment.

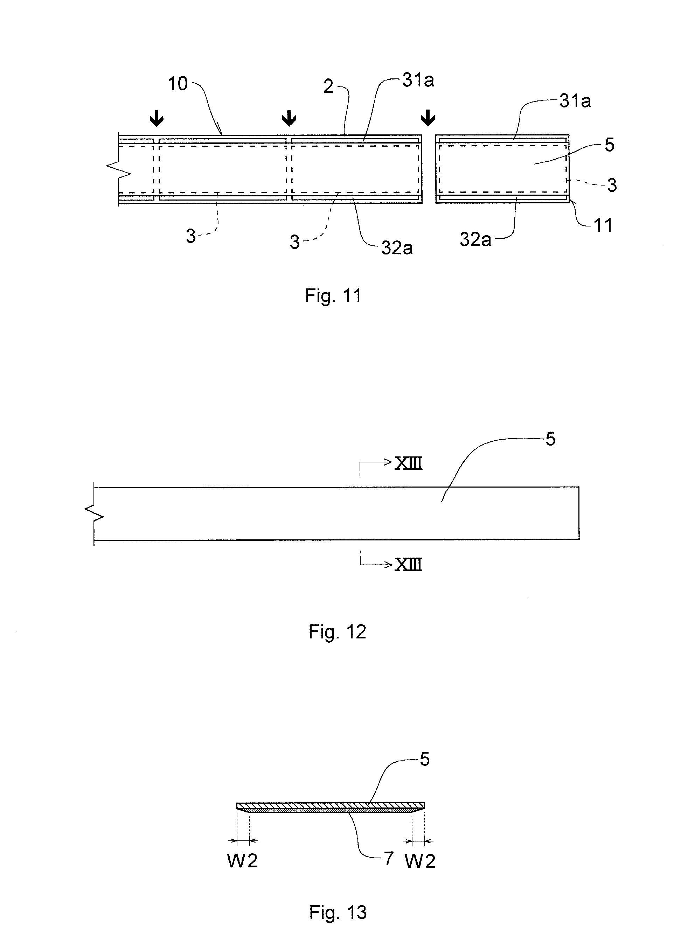

After the winding step, the laminated body 10 having the uncured adhesive layer wound into the roll is unwound and fed (refer to Fig. 11).

The laminated body 10 is cut in the boundary part between the adjacent organic EL elements with a cutting tool, whereby an individual cut piece 11 is obtained. The cut piece 11 has the same layer configuration as that of the organic EL device illustrated in Fig. 1 except that the adhesive layer is in the uncured state. Referring to Fig. 11, cutting positions are shown by arrows.

A cutting method includes the same method as in the cutting step in the first embodiment.

The obtained cut pieces 11 are moved together into a curing process apparatus, and the uncured adhesive layer in each cut piece 11 is cured (not illustrated).

After the adhesive layer has been cured, the sealing film is adhered to the organic EL element and fixed to it.

The curing process apparatus and its conditions are appropriately set according to the kind of the adhesive agent in the adhesive layer. When the adhesive agent is the thermosetting type, a heating apparatus is used, and when the adhesive agent is the photo-curing type, a light irradiation apparatus is used. By curing the uncured adhesive layer in the each cut piece, the organic EL device is provided.

According to the second embodiment also, the blocking is not generated after the laminated body has been wound, and the curing process of the adhesive layer is performed away from the manufacturing line in the roll-to-roll method, so that the adhesive layer can be cured with the relatively small curing process apparatus.

### [Third embodiment of method for manufacturing organic EL device]

According to the manufacturing method in the third embodiment, the uncured adhesive layer is provided on the back surface of the sealing film in such a manner that a thickness of the uncured adhesive layer formed at both end parts of the sealing film is smaller than a thickness of the adhesive layer formed in a region other than the both end parts of the sealing film 5. That is, according to the manufacturing method in the third embodiment, the sealing film has the uncured adhesive layer whose thickness is different between its both end parts and the region other than that.

Hereinafter, descriptions are omitted for the same configuration and effect as the manufacturing methods in the first and second embodiments, and the same term and reference number are incorporated.

As illustrated in Figs. 12 and 13, the thickness of the uncured adhesive layer 7 provided at the both end parts (first and second end parts) on the back surface of the sealing film 5 is gradually reduced toward edges of the sealing film 5. In addition, the separator on which the adhesive layer 7 is temporarily attached is not illustrated in Fig. 13, but the uncured adhesive layer 7 is normally temporarily attached to the separator.

Referring to Fig. 13, a width W2 in which the thickness of the uncured adhesive layer 7 is gradually reduced is not particularly limited, but it is preferably 10 µm to 500 µm.

The uncured adhesive layer 7 provided in the region other than the both end parts of the sealing film 5 is uniform in thickness.

The thickness of the uncured adhesive layer 7 provided other than the both end parts of the sealing film 5 is preferably 1 µm to 30 µm, as shown in the first embodiment.

According to the third embodiment, the organic EL device can be manufactured similarly to the first and second embodiments except that the sealing film 5 having the uncured adhesive layer 7 as illustrated in Figs. 12 and 13 is used in a laminating step.

In the laminating step in the third embodiment, the sealing film having the uncured adhesive layer that is thinner at both end parts than in the region other than the both end parts is laminated on the organic EL element, and the surface of the sealing film is pressed, so that the both edges of the sealing film are in close contact with both side surfaces of the organic EL element.

When the sealing film has the uncured adhesive layer whose thickness is smaller at the both end parts, similarly, the uncured adhesive layer in the region (having the larger thickness) other than the both end parts is spread to the both end parts of the sealing film after the sealing film has been pressed. Since the thickness of the uncured adhesive layer is small at the both end parts (that is, an amount of the adhesive agent is small at the both end parts), the adhesive agent that has been spread to the both end parts of the sealing film can be prevented from protruding from the both edges of the sealing film.

### [Fourth embodiment of method for manufacturing organic EL device]

According to the manufacturing method in the fourth embodiment, a sheet-shaped sealing film (instead of the belt-shaped sealing film) is formed into a shape and a size to cover the organic layer of one organic EL element. That is, according to the manufacturing method in the fourth embodiment, the sheet-shaped sealing film is laminated on each of the organic EL elements provided on the flexible substrate.

Hereinafter, descriptions are omitted for the same configuration and effect as the manufacturing methods in the first to third embodiments, and the same term and reference number are incorporated.

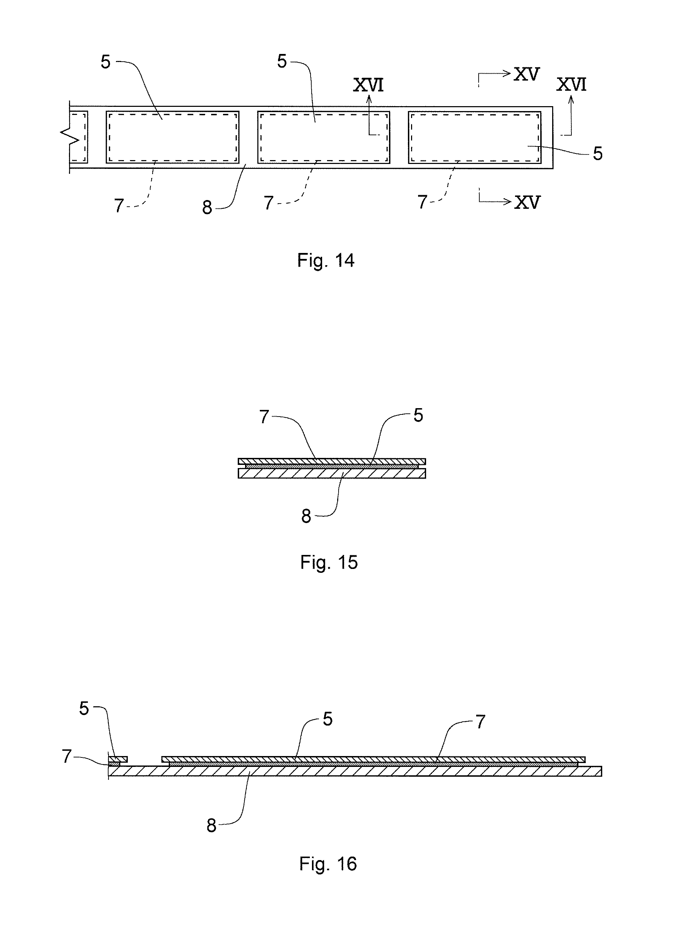

As illustrated in Figs. 14 to 16, the sealing film 5 used in the fourth embodiment is formed into a substantially rectangular shape that is slightly larger than the organic layer of the organic EL element.

The uncured adhesive layer 7 is provided on the back surface of the sealing film 5 except for the both end parts of the back surface of the sealing film 5. Preferably, as illustrated in Fig. 16, the uncured adhesive layer 7 is provided on the back surface of the sealing film 5 except for the both end parts and a pair of end parts extending in a direction perpendicular to the both end parts (peripheral end parts of the sealing film 5) of the back surface.

The plurality of sealing films 5 are temporarily attached to the belt-shaped separator 8 through the uncured adhesive layers 7 at predetermined intervals.

According to the fourth embodiment, the organic EL device can be manufactured similarly to the first to third embodiments except that the sheet-shaped sealing film 5 is used in a laminating step as illustrated in Figs. 14 to 16.

In the laminating step in the fourth embodiment, the sheet-shaped sealing film in which the uncured adhesive layer is not provided at the peripheral end parts of the sealing film is laminated on the organic EL element, and the sealing film is pressed, whereby peripheral edges of the sealing film are in close contact with the side surface of the organic EL element.

More specifically, the sealing film with the separator illustrated in Figs. 14 to 16 is laminated on the surface of the organic EL element by the laminating apparatus illustrated in Fig. 9.

The sheet-shaped sealing film having the uncured adhesive layer is separated from the separator by the peel plate of the laminating apparatus, and the one sealing film is laminated on the one organic EL element. By repeating this operation, the sealing films can be laminated on the respective organic EL elements provided on the belt-shaped flexible substrate.

After that, similar to the first to third embodiments, the sealing film 5 laminated on the organic EL element is pressed by the pressing roller, whereby the peripheral edge of the sealing film is in close contact with the side surface of the organic EL element.

After the laminated body has been wound up into the roll, similar to the first to third embodiments, the uncured adhesive layer is cured, whereby the organic EL device of the present invention can be obtained.

### INDUSTRIAL APPLICABILITY

An organic EL device of the present invention can be used for illuminating devices, image displays, or the like.

- 1: Organic EL device
- 2: Flexible substrate
- 3: Organic EL element
- 4: Cured adhesive layer
- 5: Sealing film
- 7: Uncured adhesive layer
- 10: Laminated body

## Claims

1. A method for manufacturing an organic electroluminescence device using a roll-to-roll method, comprising the steps of:
forming a plurality of organic electroluminescence elements on a belt-shaped flexible substrate;
laminating a sealing film on the plurality of organic electroluminescence elements through a thermosetting or photo-curing adhesive layer in an uncured state; and
winding a belt-shaped laminated body having the belt-shaped flexible substrate, the plurality of organic electroluminescence elements, and the sealing film, into a roll, wherein
the adhesive layer in the uncured state is provided on a back surface of the sealing film except for both end parts of the back surface of the sealing film, and
after the step of winding the laminated body, the adhesive layer is cured by applying heat or light to the laminated body.

2. A method for manufacturing an organic electroluminescence device using a roll-to-roll method, comprising the steps of:
forming a plurality of organic electroluminescence elements on a belt-shaped flexible substrate;
laminating a sealing film on the plurality of organic electroluminescence elements through a thermosetting or photo-curing adhesive layer in an uncured state; and
winding a belt-shaped laminated body having the belt-shaped flexible substrate, the plurality of organic electroluminescence elements, and the sealing film, into a roll, wherein
the adhesive layer in the uncured state is provided on a back surface of the sealing film, and a thickness of the adhesive layer in the uncured state formed on both end parts of the sealing film is smaller than a thickness of the adhesive layer formed in a region other than the both end parts of the sealing film, and
after the step of winding the laminated body, the adhesive layer is cured by applying heat or light to the laminated body.

3. The method for manufacturing an organic electroluminescence device using a roll-to-roll method according to claim 1 or 2, wherein
after the step of winding the laminated body, the adhesive layer is cured by applying heat to the laminated body wound into the roll.

4. The method for manufacturing an organic electroluminescence device using a roll-to-roll method according to claim 1 or 2, wherein
after the step of winding the laminated body, the laminated body wound into the roll is unwound, the laminated body is cut in a boundary part between the adjacent organic electroluminescence elements, and the adhesive layer is cured by applying heat or light to a cut piece.

5. The method for manufacturing an organic electroluminescence device using a roll-to-roll method according to any one of claims 1 to 4, wherein
the sealing film has a belt shape or a sheet shape.
